# EUROPEAN PATENT APPLICATION

(11) **EP 4 207 577 A1**
(43) Date of publication of application: **05.07.2023**
(21) Application number: 21861574.8
(22) Date of filing: 24.08.2021
(51) Int. Cl.: H02N 2/18

(54) **VIBRATION POWER GENERATION DEVICE, SENSOR MODULE, AND MANUFACTURING METHOD**

(30) Priority: 25.08.2020 JP 2020142106
(71) Applicant: Kyocera Corporation, Kyoto-shi Kyoto 612-8501 (JP)
(72) Inventor: KITAYAMA, Satoshi, Kyoto-shi, Kyoto 612-8501 (JP); OOKUBO, Tomoaki, Kyoto-shi, Kyoto 612-8501 (JP)
(74) Representative: TBK
(86) International application number: PCT/JP2021/031035
(87) International publication number: WO 2022/045150

(57) **Abstract**

A vibration power generation device 10 includes a weight 15, multiple beams 16, and a fixation member 17. The beams 16 extend from the weight 15 in multiple directions parallel to a single virtual plane. The beams 16 are provided with piezoelectric members 18. The fixation member 17 fixes in place, in multiple fixing regions FR, the multiple beams 16 while maintaining tension on the multiple beams 16. The multiple fixing regions FR extend along a peripheral direction around an axis in a direction perpendicular to the virtual plane. The weight 15 and the piezoelectric members 18 are surrounded by the multiple fixing regions FR.

## Description

### CROSS-REFERENCE TO RELATED APPLICATIONS

This application claims priority from Japanese Patent Application No. 2020-142106 filed in Japan on August 25, 2020, and the entire disclosure of this application is hereby incorporated by reference.

### TECHNICAL FIELD

The present disclosure relates to a vibration power generation device, a sensor module, and a manufacturing method.

### BACKGROUND OF INVENTION

With the increasing adoption of IoT, applications of sensor modules that detect various states of detection targets and transmit detection data via communication are expected to increase. Methods of generating electrical energy for driving such sensor modules from the surrounding environment are being studied. For example, for a sensor module installed in a tire, an energy generating device that generates electrical power via repeated deformation of a piezoelectric element resulting from centrifugal force and pressure caused by deformation of the tire during contact with the ground has been proposed (refer to Patent Literature 1).

### CITATION LIST

### PATENT LITERATURE

Patent Literature 1: Japanese Unexamined Patent Application Publication (Translation of PCT Application) No. 2010-515616

### SUMMARY

In a First Aspect of the present disclosure, a vibration power generation device includes: a weight, multiple beams, and a fixation member.

The multiple beams extend from the weight in multiple directions parallel to a single plane and are respectively provided with piezoelectric members.

The fixation member is configured to fix the multiple beams in place in multiple fixing regions located along a peripheral direction around an axis perpendicular to the plane when the weight and the piezoelectric members are positioned with the weight and the piezoelectric members surrounded by the multiple fixing regions while maintaining tension acting on the multiple beams.

In a Second Aspect, a sensor module includes: a vibration power generation device, a sensor, a communication unit, and a controller.

The vibration power generation device includes: a weight, multiple beams, and a fixation member.

The multiple beams extend from the weight in multiple directions parallel to a single plane and are respectively provided with piezoelectric members.

The fixation member is configured to fix the multiple beams in place in multiple fixing regions located along a peripheral direction around an axis perpendicular to the plane when the weight and the piezoelectric members are positioned with the weight and the piezoelectric members surrounded by the multiple fixing regions while maintaining tension acting on the multiple beams.

The sensor is configured to be driven by power supplied from the vibration power generation device.

The communication unit is configured to be driven by power supplied from the vibration power generation device and to communicate with an external device.

The controller is configured to be driven by power supplied from the vibration power generation device and to control the sensor and the communication unit.

In a Third Aspect, a vibration power generation device manufacturing method includes:
making the beams extend radially on a plane and applying tension to multiple beams in a direction of extension of each beam; and
fixing the multiple beams to a fixation member in fixing regions located in directions in which the beams radially extend while maintaining the tension on the beams.

### BRIEF DESCRIPTION OF THE DRAWINGS

FIG. 1 is a functional block diagram illustrating the schematic configuration of a sensor module including a vibration power generation device according to an embodiment.
FIG. 2 is a sectional view of the vibration power generation device according to the embodiment taken along a vibration direction.
FIG. 3 is a top surface view of the vibration power generation device in FIG. 2, with fixing implements and a push-in piece having been removed, looking from an opposite side from the side where a base is located.
FIG. 4 is a sectional view of an article during manufacture for illustrating a step of preliminary fixing of beams in a method of manufacturing the vibration power generation device in FIG. 2.
FIG. 5 is a sectional view of an article during manufacture for illustrating a step of applying tension to the beams in the method of manufacturing the vibration power generation device in FIG. 2.
FIG. 6 is a sectional view of an article during manufacture for illustrating a step of applying tension to the beams in a method of manufacturing a variation of the vibration power generation device in FIG. 2.
FIG. 7 is a sectional view of an article during manufacture for illustrating a step of fixing the beams in place while applying tension to the beams in a method of manufacturing a variation of the vibration power generation device in FIG. 2.
FIG. 8 is a sectional view of an article during manufacture for illustrating a step of cutting parts where the beams protrude after fixing of the beams in a method of manufacturing a variation of the vibration power generation device in FIG. 2.
FIG. 9 is a sectional view taken along a vibration direction in which another variation of the vibration power generation device in FIG. 2 and beams removed from support provided by a fixation member are illustrated next to each other.
FIG. 10 is a sectional view taken along the vibration direction in which another variation of the vibration power generation device in FIG. 2 and the beam removed from support of a fixation member are illustrated next to each other.

### DESCRIPTION OF EMBODIMENTS

Hereinafter, an embodiment of a vibration power generation device to which the present disclosure is applied will be described while referring to the drawings.

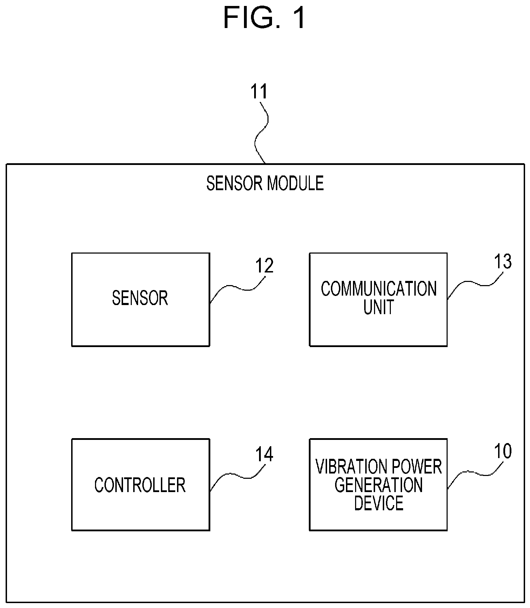

As illustrated in FIG. 1, a sensor module 11 includes a vibration power generation device 10 according to an embodiment of the present disclosure. The sensor module 11 includes a sensor 12, a communication unit 13, a controller 14, and the vibration power generation device 10. The sensor module 11 detects various states and transmits the detection results to an external device without receiving power from the outside. The sensor module 11 is, for example, used in a bridge, a train, a vehicle, a power plant, outdoor machinery, or factory equipment.

The sensor 12 is, for example, a vibration sensor, a temperature sensor, a pressure sensor, or the like. The sensor 12 is configured to detect any state of any detection target. The sensor 12 is driven by power supplied from the vibration power generation device 10.

The communication unit 13 includes a communication module that communicates with an external device via a network. The communication unit 13, for example, transmits a detection value representing a state detected by the sensor 12 to an external device in the form of a signal. The communication unit 13 may receive a command from an external device and transmit the received command to the controller 14. The communication unit 13 is driven by power supplied from the vibration power generation device 10.

The controller 14 includes one or more processors and memories. Such processors may include general-purpose processors into which specific programs are loaded to perform specific functions, and dedicated processors dedicated to specific processing. Dedicated processors may include an application specific integrated circuit (ASIC). Processors may include programmable logic devices (PLDs). PLDs may include field-programmable gate arrays (FPGAs). The controller 14 may be either a system-on-a-chip (SoC) or a system-in-a-package (SiP), in which one or more processors cooperate with each other. The controller 14 controls operation of the sensor 12 and the communication unit 13. The controller 14 is driven by power supplied from the vibration power generation device 10.

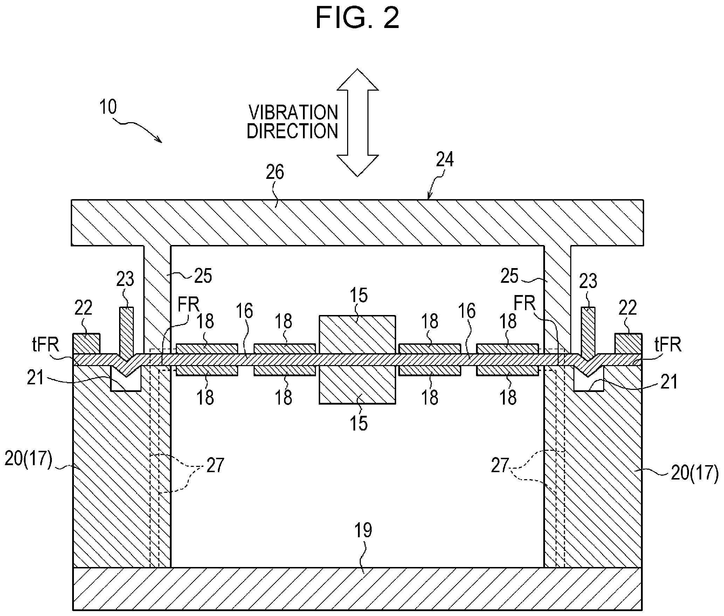

As illustrated in FIG. 2, the vibration power generation device 10 includes a weight 15, multiple beams 16, piezoelectric members 18, and a fixation member 17.

The weight 15 provides inertial force and thereby increases the vibrations of the beams 16 supported by the fixation member 17, as described later. The weight 15 may be provided on surfaces of the beams 16 located on sides in a vibration direction defined as the direction in which the beams 16 are made to vibrate. The weight 15 may be provided on both surfaces of each beam 16 in the vibration direction.

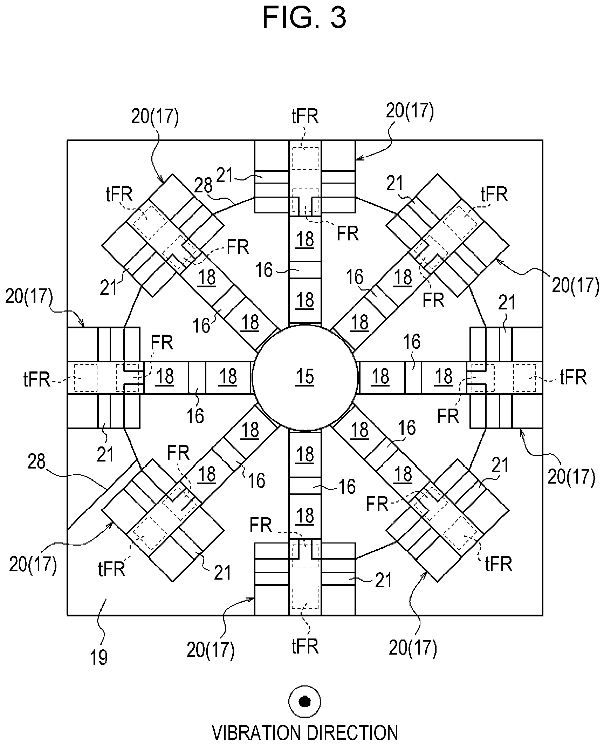

As illustrated in FIG. 3, the multiple beams 16 extend from the weight 15 in multiple different directions. In this embodiment, eight beams 16 extend from the weight 15. Two beams 16, out of the multiple beams 16, may extend from the weight 15 in straight lines in opposite directions from each other. The multiple beams 16 may consist of a single member. As illustrated in FIG. 2, the multiple directions in which the multiple beams 16 extend are parallel to a single virtual plane (plane). More specifically, the multiple beams 16 may extend in multiple directions along a single virtual plane.

The thickness of the beams 16 along the vibration direction, i.e., a direction perpendicular to the previously mentioned virtual plane, may be smaller than the width of the beams 16. Specifically, the beams 16 may be thin plates, with the surfaces of the plates being perpendicular to the vibration direction.

The beams 16, for example, may be formed of a metal such as stainless steel.

The multiple beams 16 are provided with the piezoelectric members 18. The piezoelectric members 18 may be disposed at positions where stress is generated by vibration of the beams 16. The piezoelectric members 18 may be disposed on a plane of the beams 16. The piezoelectric members 18 may be provided on surfaces of the beams 16 on one side in the vibration direction. Multiple piezoelectric members 18 may be provided in a line along the directions in which the beams 16 extend. The piezoelectric members 18 may be provided on surfaces of the beams 16 on both sides in the vibration direction.

The piezoelectric members 18 are configured to each include an insulating film, a first electrode, a piezoelectric film, and a second electrode, stacked in this order from the side where the beam 16 is located. When the beams 16 are deformed by vibrations, the piezoelectric members 18 deform together with the beams 16. As a result, when the beams 16 vibrate, stress is applied to the piezoelectric films within the piezoelectric members 18, and this stress is converted into electric power via the piezoelectric effect of the piezoelectric films. The power generated by the piezoelectric films is output to the outside the vibration power generation device 10 via the first and second electrodes.

The fixation member 17 supports the multiple beams 16 in a state where the weight 15 is suspended above a base 19 so that the weight 15 is able to vibrate in the vibration direction. The base 19 fixes support columns 20, described below, in place. As illustrated in FIG. 3, the fixation member 17 includes multiple fixing regions FR arrayed along a peripheral direction around an axis extending in the vibration direction, that is, a direction perpendicular to the previously mentioned virtual plane. In this embodiment, the fixation member 17 includes multiple support columns 20, each of which includes a fixing region FR. The multiple support columns 20 may be separated from each other along a peripheral direction around an axis perpendicular to the previously mentioned virtual plane.

The fixation member 17 fixes the multiple beams 16 in place in the multiple fixing regions FR while maintaining the tension on the multiple beams 16 in a state where the weight 15 and the piezoelectric members 18 are positioned so as to be surrounded by the multiple fixing regions FR. Thus, a state in which tension is applied to the beams 16 from the weight 15 to the fixing regions FR is maintained. A state in which tension is maintained on the multiple beams 16 may refer to a state in which the beams 16 are pulled taut so that the piezoelectric members are able to generate piezoelectricity in the vibration power generation device 10. A state in which tension is maintained on the multiple beams 16 may refer to a taut state in which the weight 15 is only capable of moving perpendicular to the virtual plane.

Tension is applied to beams 16 using any of a variety of methods. In this embodiment, tension is applied as described below.

In this embodiment, in order to apply tension, a recess 21 is formed in the fixation member 17 on the opposite side from the weight 15 in the directions of extension of the beams 16 fixed to fixing regions FR from the fixing regions FR. The recess 21 may be shaped like a groove extending along a direction perpendicular to the directions of extension of the beams 16. The fixation member 17 has temporary fixing regions tFR on the opposite side from the weight 15 along the extension directions from the recess 21.

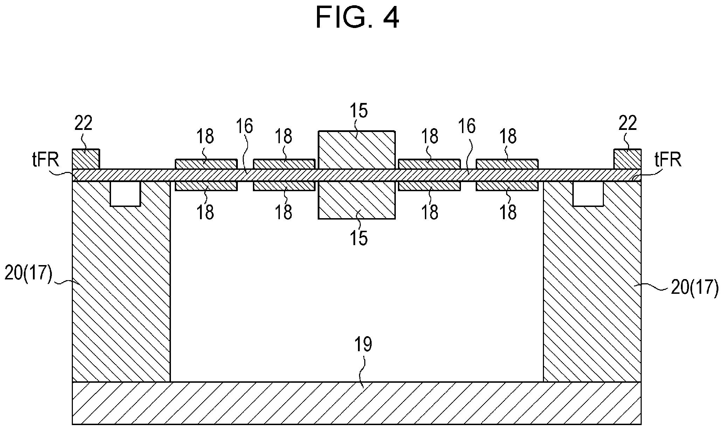

The tips of beams 16 extend radially along the previously mentioned virtual plane so as to be positioned in the fixing regions FR of the fixation member 17 of this embodiment described above. The ends of the beams 16 on the opposite side from the weight 15 are preliminarily fixed to the temporary fixing regions tFR. The fixing may be carried out using any suitable fixing method. As illustrated in FIG. 4, the ends of beams 16 may be fixed in place using fixing implements 22, such as screws, for example.

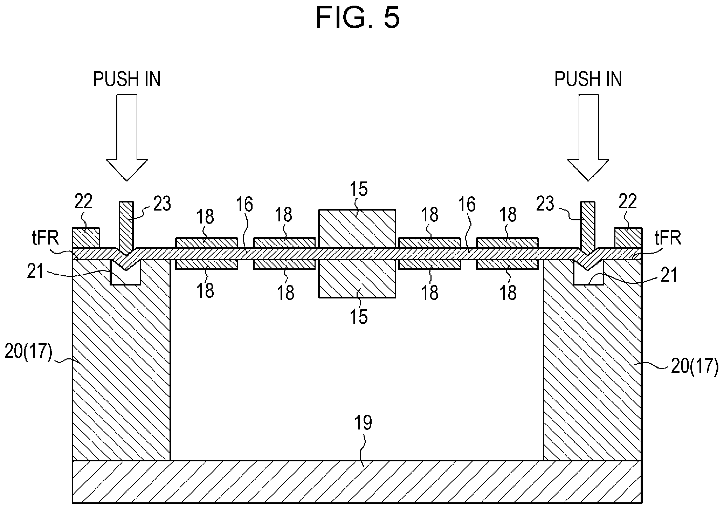

As illustrated in FIG. 5, with the ends of the beams 16 fixed in place, the parts of the beams 16 that cover the recess 21 are pushed into the recess 21 using a push-in piece 23 from a direction perpendicular to the directions in which the beams 16 extend. The pushing in action causes the beams 16 to be recessed into the recess 21. With the ends of the beams 16 fixed in place, tension is applied to the beams 16 in the directions in which the beams 16 extend by recessing the parts of the beams 16 covering the recess 21.

As illustrated in FIG. 2, while maintaining the tension applied to the beams 16, parts of the beams 16, which are nearer to the weight 15 than the parts that cover the recess 21 along the directions of extension, are fixed to fixation member 17 in the fixing regions FR, which are located in the directions in which beams 16 extend. The fixing may be carried out using any suitable method. For example, the beams 16 may be fixed in place using a fixing implement 24. The fixing implement 24 includes, for example, a pressing piece 25 positioned so as to face the multiple fixing regions FR and a body 26 that can engage with the fixation member 17. The fixing implement 24 holds the beams 16 between the pressing piece 25 and the fixing regions FR by the body 26 engaging with the fixation member 17.

Wiring lines 27 are disposed in the support columns 20. The wiring lines 27 are for providing connections to at least some of the piezoelectric members 18 on the beams 16. As illustrated in FIG. 3, the wiring lines 27 formed in the support columns 20 are electrically connected to wiring lines 28 disposed on or in the base 19. At least some of the multiple piezoelectric members 18 on the multiple beams 16 are connected in parallel with each other via the wiring lines 27 in the support columns 20 and the wiring lines 28 in the base 19. In this embodiment, the piezoelectric members 18 on the sides of the beams 16 near the fixing regions FR are connected in parallel via the wiring lines 27 in the support columns 20 and the wiring lines 28 in the base 19. The piezoelectric members 18 on the sides of the beams 16 near the weight 15 may be connected in series or parallel by wiring lines provided in or on the beams 16 near the weight 15 that cross other beams 16.

The fixation member 17 is preferably formed of a material having high rigidity, for example, a single metal such as Fe, an alloy containing Fe, Ni, Cr, and so on, stainless steel, or a non-metallic substance such as a resin.

The thus-configured vibration power generation device 10 of this embodiment includes the multiple beams 16 and the fixation member 17. The multiple beams 16 extend from the weight 15 in multiple directions parallel to a single virtual plane and are provided with the piezoelectric members 18. The fixation member 17 fixes the multiple beams 16 in place in multiple fixing regions FR located along a peripheral direction around an axis extending in a direction perpendicular to a virtual plane while maintaining the tension on the multiple beams 16 in a state where the weight 15 and the piezoelectric members 18 are positioned so as to be surrounded by the multiple fixing regions FR. In a configuration where beams extending from the weight to the perimeter are fixed separately from each other, the beams tend to flex vertically downward due to the weight. In this configuration, if the beams are flexed when not undergoing vibration, the power generated during vibration will be reduced. In contrast, in the vibration power generation device 10 having the above-described configuration, such flexion is reduced due to the fixation member 17 maintaining the tension on the multiple beams 16. Therefore, the vibration power generation device 10 is able to increase the amount of power generated because of the reduced flexion of the beams 16.

The present invention has been described based on the drawings and examples, but note that a variety of variations and amendments may be easily made by one skilled in the art based on the present disclosure. Therefore, note that such variations and amendments are included within the scope of the present invention.

For example, in this embodiment, tension is applied to the beams 16 by pushing the parts of the beams 16 covering the recess 21 using the push-in piece 23 in a state where the ends of the beams 16 on the opposite side from the weight 15 have been preliminarily fixed in the temporary fixing regions tFR. However, the method of applying tension to the beams 16 is not limited to the method described in the embodiment. For example, tension can also be applied to the beams 16 along the directions of extension using the methods described below.

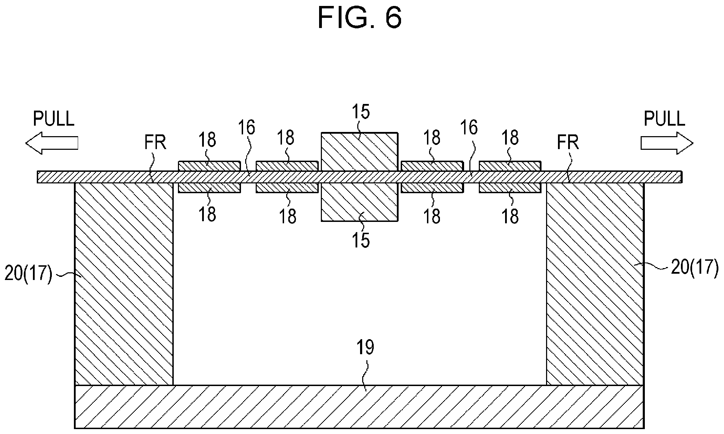

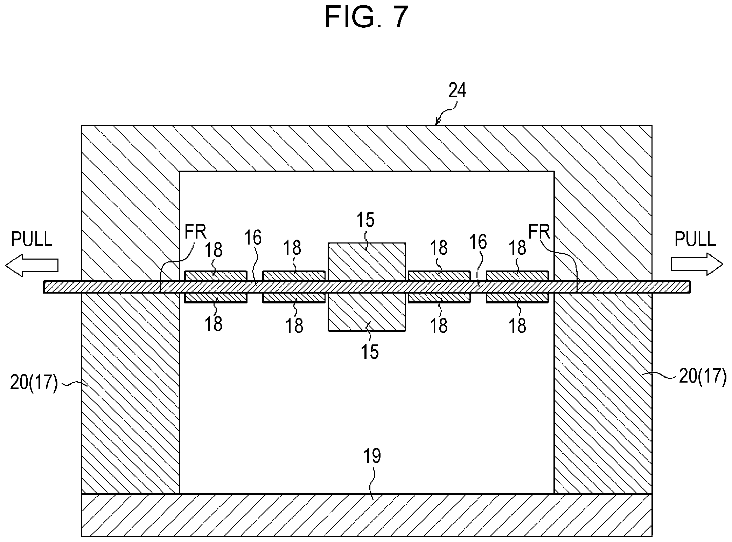

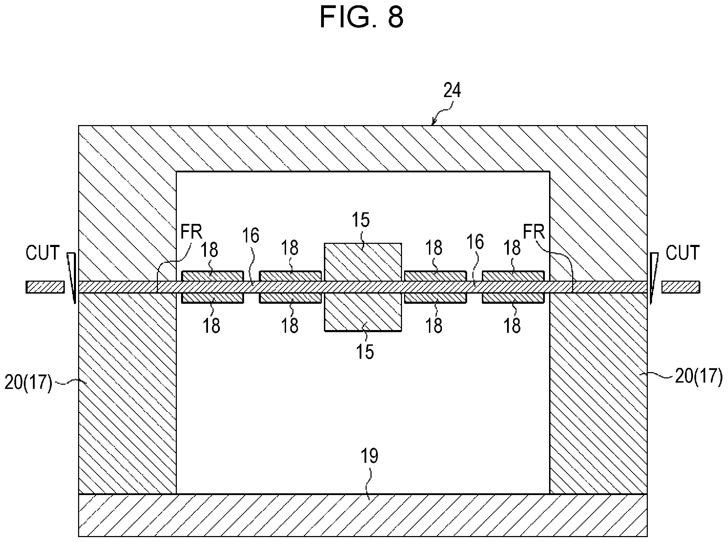

As illustrated in FIG. 6, before manufacture of the vibration power generation device 10, the beams 16 are long enough to extend beyond the fixing regions FR, which are located in radially extending directions on the virtual plane. Before manufacture of the vibration power generation device 10, tension is applied to the beams 16 by pulling the beams 16 in directions away from the weight 15 along the directions of extension. As illustrated in FIG. 7, the parts of the beams 16 covering the fixing regions FR are fixed to the fixation member 17 while maintaining the tension applied to the beams 16. The fixing may be carried out using any suitable method. For example, similarly to as in this embodiment, the beams 16 may be fixed in place using the fixing implement 24. After being fixed in place, the parts of the beams 16 protruding beyond the fixation member 17 may be cut off, as illustrated in FIG. 8.

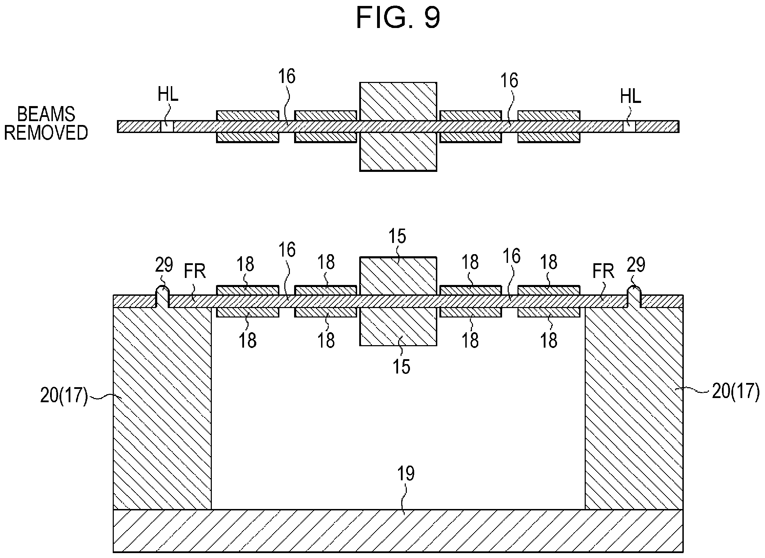

As illustrated in FIG. 9, for example, tension may be applied to the beams 16 along the directions of extension by inserting fixing pieces 29 formed in the fixing regions FR into holes HL formed in the beams 16. The fixing pieces 29 protrude perpendicular to the virtual plane. The tip of each fixing piece 29 may slope outward in a direction from the weight 15 towards the fixing piece 29. The tips of the fixing pieces 29 may be hemispherical for example. The distance from the weight 15 to the outer side of the inner surface defining each hole HL in a state where the beams 16 have been removed from support provided by the fixation member 17 may be shorter than in the state where the beams 16 are supported by the fixation member 17. For example, the above-described configuration can be realized by making the distance from the weight 15 to the outer surface of each fixing piece 29 on the outside in the direction towards the hole HL longer than the distance from the weight 15 to the outer side of the inner surface defining the hole HL when the beams 16 are removed from the support provided by the fixation member 17.

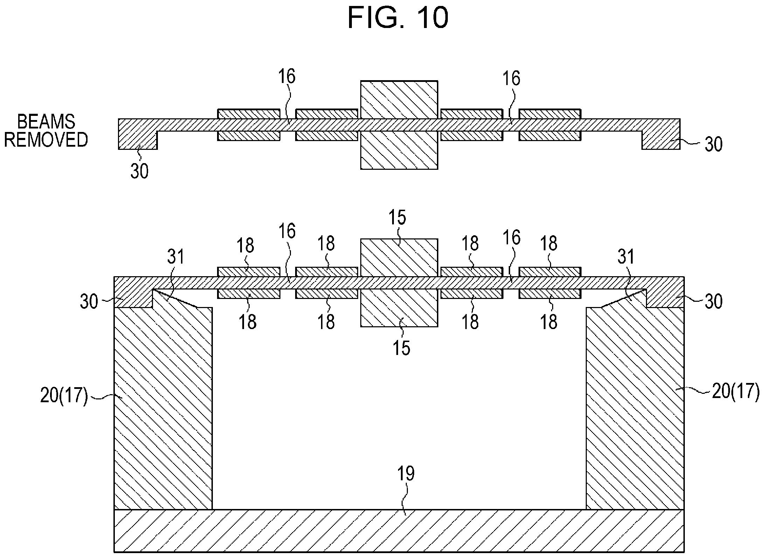

As illustrated in FIG. 10, for example, tension may be applied to the beams 16 along the directions of extension by forming engaging portions 31, in the fixing regions FR, that engage with engaging portions 30 of the beams 16 in the directions of extension of the beams 16. The distance from the weight 15 to the engaging portions 30 in a state where the beams 16 have been removed from support provided by the fixation member 17 may be shorter than that distance in a state where the beams 16 are supported by the fixation member 17. For example, the above-described configuration can be realized by making the distance from the weight 15 to the engaging portions 31 longer than the distance from the weight 15 to the engaging portions 30 when the beams 16 have been removed from support provided by the fixation member 17. The distance from the weight 15 to each engaging portion 31 is the distance between the weight 15 and the point in the engaging portion 31 where pressure is received in a direction from the engaging portion 30 towards the weight 15. The distance from the weight 15 to each engaging portion 30 is the distance between the weight 15 and the point in the engaging portion 30 where pressure is received in an opposite direction from the direction from the engaging portion 31 towards the weight 15.

### REFERENCE SIGNS

10 vibration power generation device
11 sensor module
12 sensor
13 communication unit
14 controller
15 weight
16 beam
17 fixation member
18 piezoelectric member
19 base
20 support column
21 recess
22 fixing implement
23 push-in piece
24 fixing implement
25 pressing piece
26 body
27 wiring line
28 wiring line
29 fixing piece
30 engaging portion
31 engaging portion
HL hole
FR fixing region
tFR temporary fixing region

## Claims

1. A vibration power generation device comprising:
a weight;
multiple beams extending from the weight in multiple directions parallel to a single plane;
piezoelectric members respectively provided on the multiple beams; and
a fixation member configured to fix the multiple beams in place in multiple fixing regions located along a peripheral direction around an axis perpendicular to the plane when the weight and the piezoelectric members are positioned with the weight and the piezoelectric members surrounded by the multiple fixing regions while maintaining tension acting on the multiple beams.

2. The vibration power generation device according to claim 1,
wherein a recess is formed, in the fixation member, on an opposite side from the weight along directions of extension of the beams that are fixed to a fixing region from the fixing region, and
the beams are recessed into the recess.

3. The vibration power generation device according to claim 1,
wherein the fixing regions include fixing pieces protruding perpendicular to the plane, and
the beams include holes into which the fixing pieces are inserted.

4. The vibration power generation device according to claim 1,
wherein the fixing regions and the beams are equipped with engaging portions that are configured to engage with each other in directions of extension of the beams.

5. The vibration power generation device according to any one of claims 1 to 3,
wherein the fixation member includes multiple support columns, the support columns being separated from each other along a peripheral direction around an axis perpendicular to the plane, and the support columns respectively including the fixing regions, and
at least some of the multiple piezoelectric members provided on the multiple beams are connected in series or parallel with each other via wiring lines provided on or in the support columns and on or in a base configured to fix the support columns in place.

6. A sensor module comprising:
the vibration power generation device according to any one of claims 1 to 5;
a sensor configured to be driven by power supplied from the vibration power generation device;
a communication unit configured to be driven by power supplied from the vibration power generation device and to communicate with an external device; and
a controller configured to be driven by power supplied from the vibration power generation device and to control the sensor and the communication unit.

7. The sensor module according to claim 6,
wherein the sensor module is configured to be used in a bridge, a train, a vehicle, a power plant, outdoor machinery, or factory equipment.

8. A vibration power generation device manufacturing method comprising: making the beams extend radially on a plane and applying tension to multiple beams in a direction of extension of each beam; and
fixing the multiple beams to a fixation member in fixing regions located in directions in which the beams radially extend while maintaining the tension on the beams.
